# EUROPEAN PATENT SPECIFICATION

(11) **EP 4 669 922 B1**
(45) Date of publication and mention of the grant of the patent: **23.09.2026**
(21) Application number: 23710485.6
(22) Date of filing: 24.02.2023
(51) Int. Cl.: F28D 15/02

(54) **THERMOSIPHON HEAT SINK**
THERMOSIPHON-KÜHLKÖRPER
DISSIPATEUR THERMIQUE À THERMOSIPHON

(43) Date of publication of application: 31.12.2025
(73) Proprietor: Telefonaktiebolaget LM Ericsson (publ), 164 83 Stockholm (SE)
(72) Inventor: VAN WYK, Stevin, 187 72 TÄBY (SE); HELLSTRÖM, Georg, 117 67 Stockholm (SE); RABHI, Achref, 177 54 Järfälla (SE); GALLEGO MARCOS, Ignacio, 183 30 Täby (SE); SANDMAN, Maria, 754 23 Uppsala (SE)
(74) Representative: Ericsson
(86) International application number: PCT/SE2023/050167
(87) International publication number: WO 2024/177539

(56) References cited:
- EP-A1- 4 019 875
- WO-A1-2022/184244
- US-A1- 2023 039 213

## Description

### TECHNICAL FIELD

Disclosed are embodiments related to thermosiphon heat sinks. Such hat sinks are, for instance, known from WO2022/184244.

### BACKGROUND

Thermosiphon heat sinks (TSHSs) are powerful solutions for high heat removal. Classic TSHSs are two-phase cooling technologies, based on phase-change and latent heat removal. A TSHS usually operates without any external power inputs as pumping, and the coolant is driven by gravitational forces due to density difference between the liquid and vapor phases inside the TSHS. The resulting coolant mass flow rates are usually small, which affects the associated heat transfer rates. With traditional TSHSs, the heat removal operation is limited by the small resulting coolant mass flow rate.

Thermosiphon solutions based on gravity driven natural circulation of the coolant results in the associated mass flow rates to be low and strongly dependent on the applied heat. Adding pumping power to increase the coolant mass flow rate, however, leads to increased pumping/energy cost as well as pump reliability issues. Using a pumped thermosiphon solution requires an external pump and extra power consumption for the cooling operation plus all the problems related the reliability of pumps.

### SUMMARY

Certain challenges presently exist. For instance, existing TSHS designs have the weakness of not maximizing heat dissipation potential. Also due to the location of the vapor transport and/or condenser conduits, conventional TSHS designs are not easily scalable in the fin height direction (i.e., the direction normal to the base of the base of the structure towards the extremities of the fins). The location of these conduits also limits the flexibility to explore design features that could further enhance the heat transfer efficiency, such as louvers on the sides of the fins, which would allow for fresh air to pass freely towards the hotter parts of the fin structure, thereby improving the heat dissipation capacity.

Accordingly, in one aspect there is provided a thermosiphon heat sink (TSHS) for use in cooling at least a first component of a communication system (i.e., for use in removing heat from at least the first component). The TSHS includes a base and a first fin attached to the base. The base includes a first cavity filled with a liquid mixture; an evaporator above the first cavity and comprising a first evaporation conduit; a separator separated from the first cavity by the evaporator, wherein the first evaporation conduit is in fluid communication with the first cavity and the separator and the first evaporation conduit is configured to enable liquid and vapor present in the first evaporation conduit to flow upwardly to the separator; and a riser comprising a first riser conduit extending upwardly from the separator for enabling vapor to flow upwardly into a vapor distribution region. The first fin includes a condenser comprising a first downcomer conduit in fluid communication with the vapor distribution region and the first cavity, the first downcomer conduit being configured for receiving vapor flowing out of the vapor distribution region, facilitating condensation of the received vapor, and enabling liquid resulting from the condensation of the received vapor to flow downwardly to the first cavity by the force of gravity.

An advantage of the embodiments disclosed herein is that they significantly increase heat removal.

### BRIEF DESCRIPTION OF THE DRAWINGS

The accompanying drawings, which are incorporated herein and form part of the specification, illustrate various embodiments.
FIG. 1 illustrates a system according to an embodiment.
FIG. 2 is a side view of the base and the first fin according to an embodiment.
FIG. 3 illustrates various cavities and conduits within the TSHS according to an embodiment.
FIG. 4 further illustrates various cavities and conduits within the base according to an embodiment.
FIG. 5 illustrates a TSHS base according to some embodiments.
FIG. 6 illustrates a TSHS according to some embodiments.
FIG. 7 illustrates a condenser according to an embodiment.
FIG. 8 illustrates a fin according to an embodiment.
FIG. 9 illustrates a fin according to an embodiment.

### DETAILED DESCRIPTION

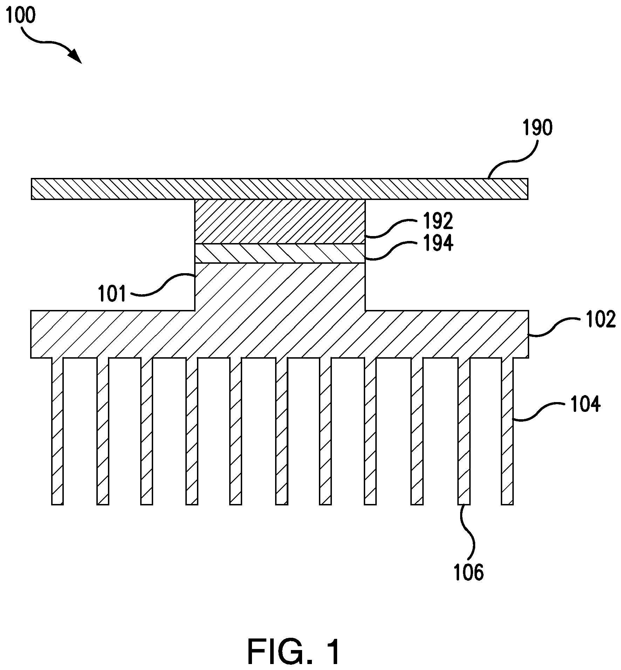

FIG. 1 illustrates a system 100 according to an embodiment. System 100 may be an antenna system or other communication system. System 100 includes a component 192 (e.g., a power amplifier, a chip, a circuit) that needs to be cooled. In the illustrated embodiment, component 192 is connected to a printed circuit board 190 and a TSHS 101 is connected (directly or indirectly) to component 192 to draw heat away from component 192, thereby preventing component 192 from overheating. In the illustrated embodiment, TSHS 101 is connected to component 192 via a thermal interface 194. Thermal interface 194 may comprise one component or multiple separate components combined together. As shown in FIG. 1, TSHS 101 includes a base 102 (a.k.a., base plate 102) and a plurality of fins attached to the base, including a first fin 104. In some embodiments, TSHS 101 may be integrated (e.g., welded) into another structure but nevertheless connected to component 192.

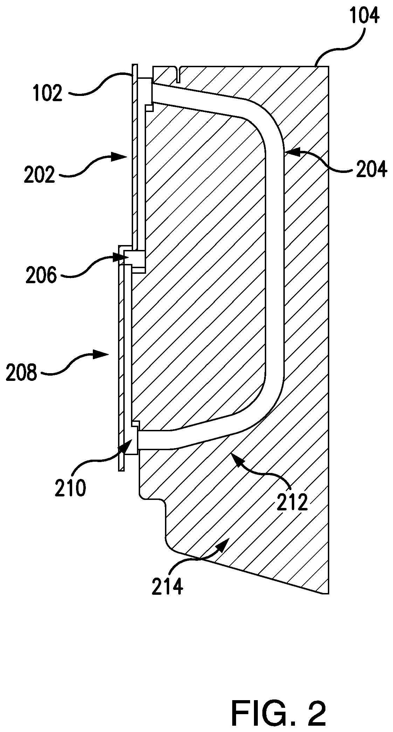

FIG. 2 is a side view of the base 102 and the first fin 104, and illustrates components of each that facilitate drawing heat away from component 192.

As illustrated in FIG. 2, the base 102 includes a first cavity 210, which is filled with a liquid mixture. In one embodiment, the liquid mixture consists of a single liquid, but in another embodiment the liquid mixture comprises two or more liquids, where the some of the liquids may have a different boiling point that the other liquids that comprise the mixture.

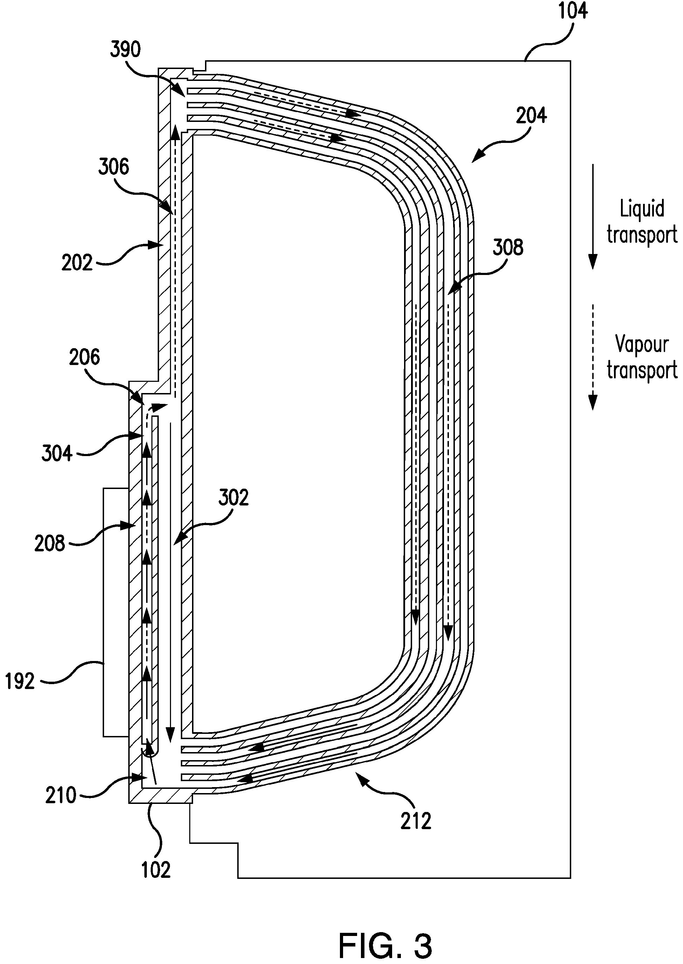

Base 102 also includes an evaporator 208 above the first cavity 210. As shown in FIG. 3, evaporation 208 includes a first evaporation conduit 304, which is at least partially filled with the liquid mixture.

Base 102 also includes a separator 206 separated from the first cavity 210 by the evaporator 208, wherein the first evaporation conduit 304 is in fluid communication with the first cavity 210 and the separator 206 and the first evaporation conduit 304 is configured to enable liquid and vapor present in the first evaporation conduit to flow upwardly to the separator 206. In this embodiment, separator 206 consists of a chamber in which the liquid in the chamber will flow into a return conduit 302 and the vapor in the chamber will flow into a riser conduit 306 (see FIG. 3).

Base 102 also includes a riser 202. As shown in FIG. 3, riser 202 includes a first riser conduit 306 extending upwardly from the separator 206 for enabling vapor present in the separator 206 to flow upwardly into a vapor distribution region 390.

As shown in FIG. 3, in some embodiments, base 102 also includes a first liquid return conduit 302 in fluid communication with the separator 206 and the first cavity 210. The first liquid return conduit 302 enables liquid present in the separator 206 to flow downwardly from the separator 206 to the first cavity 210 by the force of gravity.

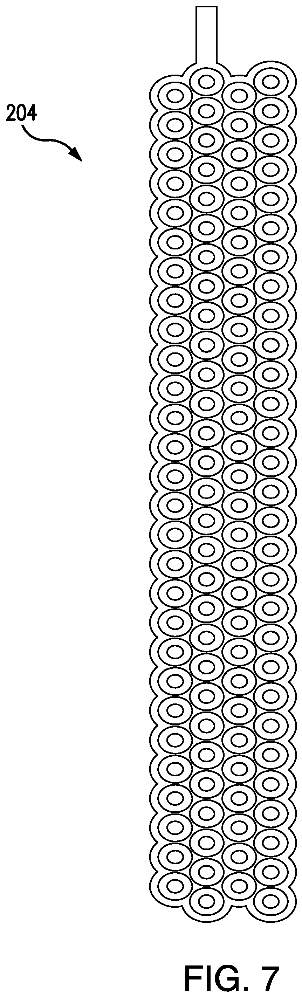

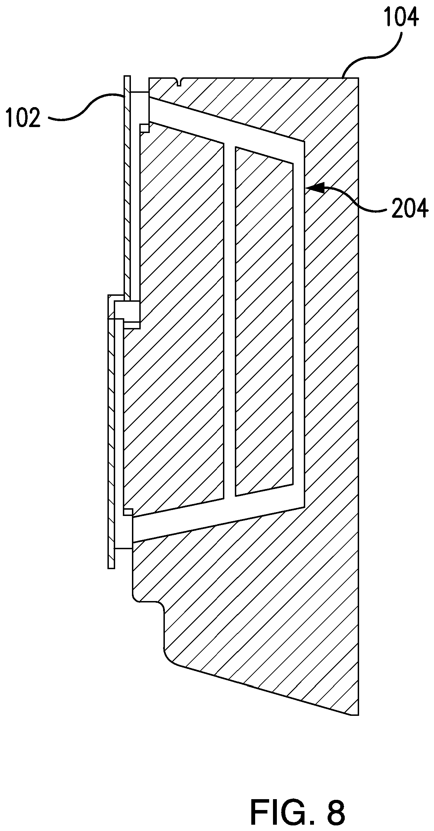

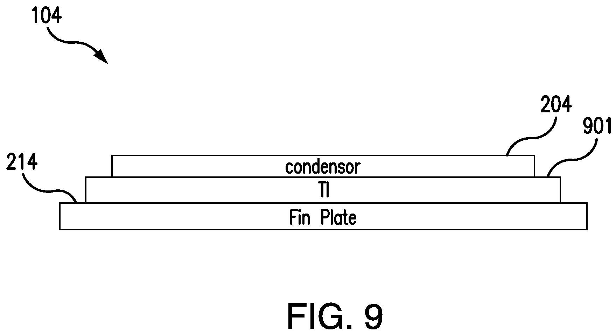

As also illustrated in FIG. 2 (see also FIG. 8), the first fin 104 includes a plate 214 (e.g., a smooth, flat, thin piece of material, which may be metal or metallic) and a condenser 204 attached to a side of the plate 214 or housed within the plate 214. In one embodiment, illustrated in FIG. 9, condenser 204 is attached to the side of plate 214 via a thermal interface 901. As shown in FIG. 3, condenser 204 includes several downcomer conduits, including a first downcomer conduit 308, each in fluid communication with the vapor distribution region 390 and the first cavity 210. While FIG. 2 and FIG. 3 illustrates condenser 204 as having a U shape, other shapes are contemplated (see e.g., FIG. 7 and FIG. 8). Additionally, while the downcomer conduits of condenser 204 shown in FIG. 3 are illustrated as being straight, in some embodiments they may be curved, as illustrated in FIG. 7, or spread apart, as illustrated in FIG. 8, so that the conduits of condenser 204 are distributed along the surface of plate 214.

First downcomer conduit 308 is configured for: receiving vapor flowing out of the vapor distribution region 390, facilitating condensation of the received vapor, and enabling liquid resulting from the condensation of the received vapor to flow downwardly to the first cavity 210 by the force of gravity through a return section 212 of condenser 204. The other downcomer conduits are likewise configured. In one embodiment, return section 212 is not parallel with the ground (i.e., not perpendicular to the gravitational vector direction), but, as shown in FIG. 3, is angled upwardly (at least by 5 degrees) to facilitate the flow of liquid into cavity 210 from condenser 204. That is, the end of section 212 that abuts cavity 210 is lower than the opposite end of section 212.

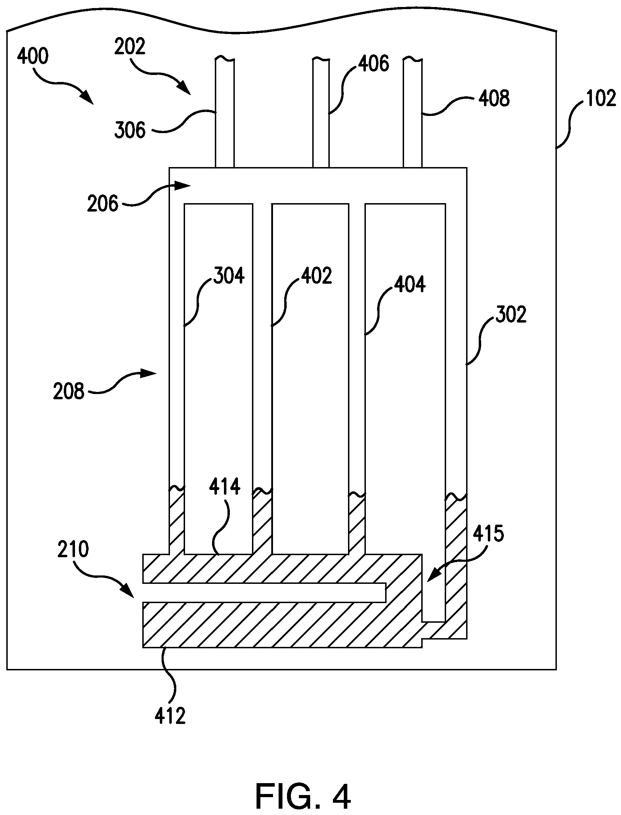

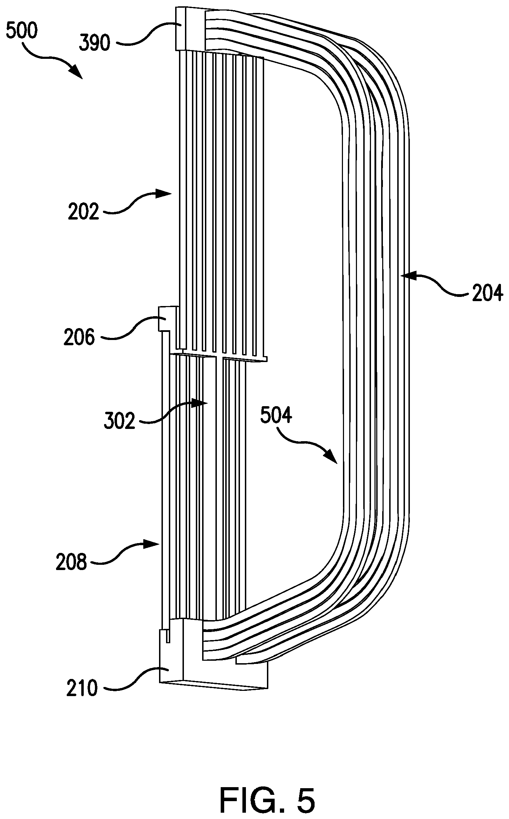

FIG. 4 further illustrates base 102 according to some embodiments. As shown in FIG. 4, base 102 includes a fluid storage and transport structure 400 that includes cavity 210, evaporator 208, separator 206, and return conduit 302. In some embodiments, base 102 includes two or more of these structures. For example, in one embodiment, TSHS 101 includes N fins, and base includes N/2 of the fluid storage and transport structures 400 (e.g., one structure per pair of fins). An example of this is illustrated in FIG. 5, which shows condenser 204 of fin 104 and a condenser 504 of another fin (e.g., fin 106) being in fluid communication cavity 210 and vapor distribution region 390.

In the embodiment shown in FIG. 4, cavity 210 includes a first chamber 414 in fluid communication with a second chamber 412; evaporator 208 includes not only conduit 304, but also conduits 402 and 404, each of which is in direct fluid communication with upper cavity 414 and allows vapor to rise to separator 206; and riser 202 includes not only conduit 306, but also conduits 406 and 408, each of which allows vapor to rise to vapor distribution region 390. In one embodiment, a channel 415 connects the chamber 414 to the chamber 412.

Given the design shown in FIG. 2 and FIG. 3, when component 192 heats, the heat generated by component 192 heats the liquid mixture contained in the evaporator 208 until nucleate boiling is initiated. As the temperature increases, a mixture of liquid and vapor is rises vertically (in the gravitational vector direction), above the original liquid level, wetting the higher up surfaces and increasing the vaporization area. This increases the robustness for vertical heat source placement. TSHS 101 is dimensioned so that the mixture reaches this point under design loads. At this point it is desirable to separate the fluid phases to allow for vapor to rise through riser 202 to the condensers 204 in each fin. That is, the vapor is transported via the riser 202 in the base towards a vapor distribution region 390 (see FIG. 3), to enter the intended condenser (e.g., condenser 204). Heat is also partially dissipated in the distribution region 390. The bulk of the liquid is returned to cavity 210. The bulk of the heat is dissipated in the fin structured condenser 204, facilitated by efficient vapor transport via the embedded conduits (e.g., conduit 308).

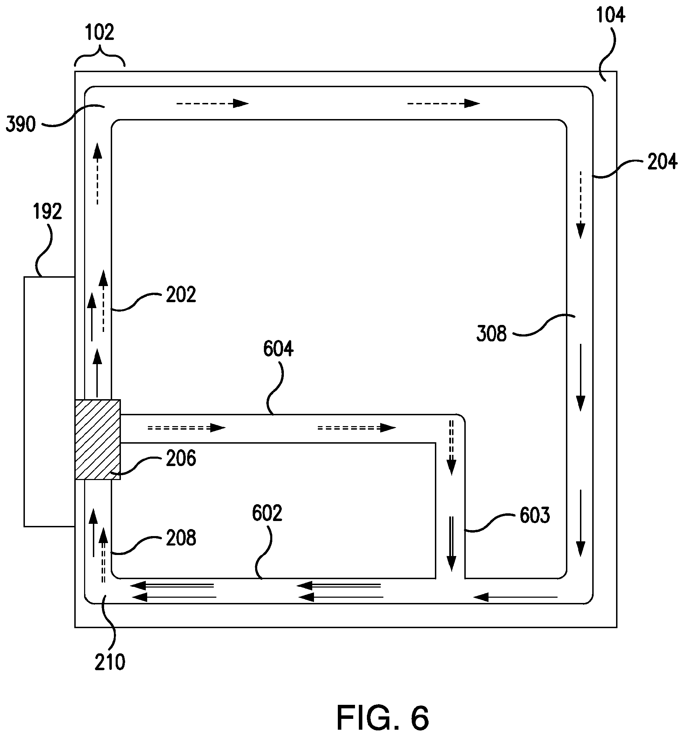

FIG. 6 illustrates another embodiment. The embodiment shown in FIG. 6 is particularly applicable when the liquid mixture comprises two or more liquids and at least one of the liquids has a different boiling point than the other liquids that comprise the mixture. For example, as shown in FIG. 6, the liquid mixture may consist of a first liquid (Liquid 1) (e.g., water) with a boiling temperature (T1) and a second liquid (Liquid 2) (e.g., an alcohol) with a boiling temperature (T2) that is lower than T1. In FIG. 6, the solid single line arrows indicate the direction of flow of Liquid 1, the dashed single line arrows indicate the direction of flow of the vapor produced by the boiling of Liquid 1 (hereafter Vapor 1), the solid double line arrows indicate the direction of flow of Liquid 2, and dashed double line arrows indicate the direction of the flow of the vapor produced by the boiling of Liquid 2 (hereafter Vapor 2).

Initially, Liquid 1 and Liquid 2 will be present within first cavity 210, evaporator 208 and a common return section 602 of conduit 308, as illustrated in FIG. 6.

When heat is introduced to the system by component 192, the heat will be conducted through the base 102, thereby heating any fluid within cavity 210, evaporator 208, and riser 202; eventually, the boiling temperature of Liquid 2 (T2) will be reached. Therefore, Liquid 2 will evaporate, boil and change phase from liquid to vapor, while Liquid 1 keeps its phase as liquid. Boiled Liquid 2 (bubbles) will go up in 208 evaporator (e.g., evaporation conduit 304) under the gravity effect (vapor has a lower density than liquid), and it will contribute to Liquid 1 motion up against the gravity.

Liquid 2 evaporation will contribute as well in cooling of component 192. This motion of Liquid 1 in its liquid state, caused by the bubbling of Liquid 2, will enhance the heat transfer rate (higher velocity leads to higher heat transfer rate). Then the mixture of Liquid 1 and Vapor 2 will be separated by separator 206, the Liquid 1 will be directed to flow upwardly into the riser 202 section (e.g., conduit 306), while Vapor 2 will be directed into a conduit 604, which is in fluid communication with a second downcomer conduit 603 (conduit 604 and conduit 603 may be a single conduit), which is in fluid communication first condenser 204 (e.g., in fluid communication with conduit 308 of first condenser 204), which feeds fluid into cavity 210. In this embodiment, separator 206 may comprise a chamber and a filter (e.g., a sponge) positioned in the chamber so that vapor in the chamber (i.e., Vapor 2) will be forced to flow into conduit 604, while liquid in the chamber (i.e., Liquid 1) will not flow into conduit 604.

As illustrated in FIG. 6, the riser 202 is in this embodiment is configured for receiving Liquid 1 in liquid evaporating state, that is the liquid is evaporating which means it is bubbling. , and the second downcomer conduit 603 is configured for: receiving vapor flowing out from the separator 206, facilitating condensation of the received Vapor 2, and enabling liquid resulting from the condensation of the received Vapor 2 to flow downwardly into conduit 308, and from there into the first cavity 210 by the force of gravity. Vapor 2 will condense in second downcomer conduit 603 and changes phase from vapor to liquid, and under the gravity effect it enter conduit 308 contributing more to Liquid 1 (main coolant) circulation speed.

In addition, the absorbed heat by Liquid 2 in evaporator 208 will be dissipated by condensation and air free convection in second downcomer conduit 603, which will allow a portion of component 192 cooling. Liquid 1 (the main coolant) will flow in riser 202, where it is subject of boiling when it reaches its saturation temperature (T1). It will then cool down component 192 by phase-change, and the latent heat absorbed in riser 202 by Liquid 1 will be the main cooling mechanism for component 192.

Within the riser 202, Liquid 1 will evaporate into Vapor 1 which will flow into conduit 308 where it is subject to condensation and phase change from vapor to liquid, and mixes again with Liquid 2 in an end portion of conduit 308 (a.k.a., the common return section) and in first cavity 210. The prescribed operation will be naturally repeated as long as heat is applied to the system.

As illustrated above, cooling is enhanced by introducing another fluid (e.g., Liquid 2) to the main coolant (e.g., Liquid 1), wherein Liquid 2 operates as a natural pump when it changes phases. This enhancement is performed without any additional energy cost, and it represents a reliable solution which is lacking in pumped solutions.

Boiling region of the main coolant (Liquid 1, riser 202) is made separate to the boiling region of the pumping fluid (Liquid 2, evaporator 208) to decrease the binary boiling resistance effect which can deteriorate the cooling performance. The same reason is behind making the main coolant (Liquid 1) condensation zone (first downcomer conduit 308) separate to the pumping fluid (Liquid 2) condensation zone (second downcomer conduit 603) to remove the binary condensation resistance effect. This is the main reason, of embodiment in FIG. 6, of having the separator 206.

### Conclusion and Advantages

TSHS 101 improves thermal dissipative capacity and empowers the potential for design simplicity and flexibility. As shown in the figures, the general structure of TSHS includes: 1) a base that includes an evaporator containing a fill of the working liquid where heat is transported by vaporization; 2) a riser integrated into to the base that extends all the way across the length of the base; 3) a condenser attached to or inside of a fin to transport the vapor and allow it to condense (in one embodiment, transport paths are specified so as to limit the total path rotation to 180° as this improves the scalability in the fin height which determines the volume of the structure); and 4) an angled return section of the condenser (e.g., greater than 5 degrees) to avoid liquid collection in the condenser to maximize performance and robustness in normal operation.

TSHS 101 has at least the following strengths over previous technologies: 1) maximizing natural convection heat transfer area; 2) maximizing condensation area in connection with the natural convection area (the fluid/vapor transport dynamic also increases the evaporative area due to dynamic wetting and this allows large flexibility when placing the heat source in the vertical direction (in the gravitational vector direction), which is normally not a strength of traditional fill based TSHSs; 3) improved heat sink volume scalability (fin height); 4) improved mechanical design flexibility to empower introduction of structural enhancements; and 5) the base thickness is as slim as physically possible, decreasing waste volume, due to the design directions of the fluid paths being in the same plane, moving away from each other.

TSHS of embodiment described in FIG. 6 has the further strengths: higher flow rate of the coolant compared to regular thermosiphons which will increase the heat transfer operation resulting in better cooling performance. High coolant flow rate made by natural means by introducing a pumping fluid as described results in that there will be no need for external pumping power. This will further lead to better system reliability compared to pumped thermosiphons since the pumping is done naturally by another fluid, in a fully closed system. Different evaporation and condensation zones for the coolant and the pumping fluid, to avoid additional thermal resistance due to binary boiling and binary condensation.

## Claims

1. A thermosiphon heat sink (101) for use in cooling at least a first component (192) of a communication system (100), comprising:
a base (102); and
a first fin (104) attached to the base, wherein
the base comprises:
a first cavity (210) filled with a liquid mixture;
a first evaporator (208) above the first cavity (210) and comprising a first evaporation conduit (304);
a first separator (206) separated from the first cavity (210) by the first evaporator (208), wherein the first evaporation conduit (304) is in fluid communication with the first cavity (210) and the first separator (206) and the first evaporation conduit (304) is configured to enable liquid and vapor present in the first evaporation conduit to flow upwardly to the first separator (206);
a first riser (202) comprising a first riser conduit (306) extending upwardly from the first separator (206) for enabling vapor to flow upwardly into a first vapor distribution region (390), and
the first fin (104) comprises:
a first condenser (204) comprising a first downcomer conduit (308) in fluid communication with the first vapor distribution region (390) and the first cavity (210), the first downcomer conduit (308) being configured for: receiving vapor flowing out of the first vapor distribution region (390), facilitating condensation of the received vapor, and enabling liquid resulting from the condensation of the received vapor to flow downwardly to the first cavity (210) by the force of gravity.

2. The thermosiphon heat sink of claim 1, wherein the base (102) also includes a first liquid return conduit (302) in fluid communication with the first separator (206) and the first cavity (210), the first liquid return conduit (302) for enabling liquid present in the first separator (206) to flow downwardly from the first separator (206) to the first cavity by the force of gravity.

3. The thermosiphon heat sink of claim 1 or 2, further comprising a second fin (106) comprising a second condenser (504) in fluid communication with the vapor distribution region (390) and the first cavity (210) for receiving vapor flowing out of the vapor distribution region (390), facilitating condensation of the received vapor, and enabling liquid resulting from the condensation of the received vapor to flow downwardly to the first cavity (210) by the force of gravity.

4. The thermosiphon heat sink of any one of claims 1-3, wherein the first cavity comprises a first chamber (414) above a second chamber (412) and a channel (415) connects the first chamber to the second chamber.

5. The thermosiphon heat sink of any one of claims 1-4, wherein
the first condenser (204) includes a return section (212) connected to the first cavity (210), and
the return section (212) is angled upwardly by at least 5 degrees to facilitate the flow of liquid into the first cavity (210) from the first condenser (204).

6. The thermosiphon heat sink of any one of claims 1-5, wherein
the first riser comprises N riser conduits, and
the first condenser comprises a downcomer conduit for each one of the N riser conduits.

7. The thermosiphon heat sink of any one of claims 1-6, wherein
the liquid mixture comprises a first liquid with a first boiling temperature and a second liquid with a second boiling temperature lower than the first boiling temperature of the first liquid.

8. The thermosiphon heat sink of claim 7, wherein the riser (202) is configured for receiving the first liquid from the separator (206).

9. The thermosiphon heat sink of any one of claims 1-8, wherein
the first fin further comprises a second downcomer conduit (603) in fluid communication with the separator (206) and the first cavity (210), the second downcomer conduit (603) being configured for: receiving vapor flowing out from the separator (206), facilitating condensation of the received vapor, and enabling liquid resulting from the condensation of the received vapor to flow downwardly towards the first cavity (210) by the force of gravity.

10. The thermosiphon heat sink of claim 9, wherein the second downcomer conduit (603) is further configured for receiving vapor of the second liquid with a second boiling temperature and wherein the first downcomer conduit (308) is further configured for receiving vapor of the first liquid with a first boiling temperature higher than the second boiling temperature.

11. The thermosiphon heat sink of any one of claims 1-6, wherein the liquid mixture consists of a single liquid.

12. A communication system (100), comprising:
a component (192); and
the TSHS (101) of claim 1 connected to the component (192).

13. The communication system of claim 12, wherein the component comprises an power amplifier.

## Patentansprüche

1. Thermosiphon-Kühlkörper (101) zur Verwendung bei der Kühlung mindestens einer ersten Komponente (192) eines Kommunikationssystems (100), umfassend:
eine Basis (102); und
eine erste Finne (104), die an der Basis befestigt ist, wobei
die Basis Folgendes umfasst:
einen ersten Hohlraum (210), der mit einem Flüssigkeitsgemisch gefüllt ist;
einen ersten Verdampfer (208), der sich über dem ersten Hohlraum (210) befindet und eine erste Verdampfungsleitung (304) umfasst;
einen ersten Separator (206), der durch den ersten Verdampfer (208) von dem ersten Hohlraum (210) getrennt ist, wobei die erste Verdampfungsleitung (304) mit dem ersten Hohlraum (210) und dem ersten Separator (206) in Fluidverbindung steht und die erste Verdampfungsleitung (304) so ausgelegt ist, dass sie ermöglicht, dass Flüssigkeit und Dampf, die in der ersten Verdampfungsleitung vorhanden sind, nach oben in den ersten Separator (206) strömen;
einen erstes Steigrohr (202), das eine erste Steigrohrleitung (306) umfasst, die sich aus dem ersten Separator (206) erstreckt, um zu ermöglichen, dass Dampf nach oben in eine erste Dampfverteilungsregion (390) strömt, und
die erste Finne (104) Folgendes umfasst:
einen ersten Kondensator (204), der eine erste Fallrohrleitung (308) in Fluidverbindung mit der ersten Dampfverteilungsregion (390) und dem ersten Hohlraum (210) umfasst, wobei die erste Fallrohrleitung (308) zu Folgendem ausgelegt ist: Empfangen von Dampf, der aus der ersten Dampfverteilungsregion (390) strömt, Erleichtern der Kondensation des empfangenen Dampfs und Ermöglichen, dass Flüssigkeit, die aus der Kondensation des empfangenen Dampfs resultiert, durch die Schwerkraft nach unten in den ersten Hohlraum (210) strömt.

2. Thermosiphon-Kühlkörper nach Anspruch 1, wobei die Basis (102) außerdem eine erste Flüssigkeitsrücklaufleitung (302) in Fluidverbindung mit dem ersten Separator (206) und dem ersten Hohlraum (210) umfasst, wobei die erste Flüssigkeitsrücklaufleitung (302) dazu dient, zu ermöglichen, dass die in dem ersten Separator (206) vorhandene Flüssigkeit durch die Schwerkraft aus dem ersten Separator (206) nach unten in den ersten Hohlraum strömt.

3. Thermosiphon-Kühlkörper nach Anspruch 1 oder 2, umfassend eine zweite Finne (106), die einen zweiten Kondensator (504) in Fluidverbindung mit der Dampfverteilungsregion (390) und dem ersten Hohlraum (210) zum Empfangen von Dampf, der aus der Dampfverteilungsregion (390) strömt, Erleichtern der Kondensation des empfangenen Dampfs und Ermöglichen umfasst, dass Flüssigkeit, die aus der Kondensation des empfangenen Dampfs resultiert, durch die Schwerkraft nach unten in den ersten Hohlraum (210) strömt.

4. Thermosiphon-Kühlkörper nach einem der Ansprüche 1-3, wobei der erste Hohlraum eine erste Kammer (414) über einer zweiten Kammer (412) umfasst und ein Kanal (415) die erste Kammer mit der zweiten Kammer verbindet.

5. Thermosiphon-Kühlkörper nach einem der Ansprüche 1-4, wobei
der erste Kondensator (204) einen Rücklaufabschnitt (212) umfasst, der mit dem ersten Hohlraum (210) verbunden ist, und
der Rücklaufabschnitt (212) nach oben um mindestens 5 Grad abgewinkelt ist, um den Strom von Flüssigkeit aus dem ersten Kondensator (204) in den ersten Hohlraum (210) zu erleichtern.

6. Thermosiphon-Kühlkörper nach einem der Ansprüche 1-5, wobei
das Steigrohr N Steigrohrleitungen umfasst und
der erste Kondensator eine Fallrohrleitung für jede der N Steigrohrleitungen umfasst.

7. Thermosiphon-Kühlkörper nach einem der Ansprüche 1-6, wobei
das Flüssigkeitsgemisch eine erste Flüssigkeit mit einer ersten Siedetemperatur und eine zweite Flüssigkeit mit einer zweiten Siedetemperatur umfasst, die niedriger als die erste Siedetemperatur der ersten Flüssigkeit ist.

8. Thermosiphon-Kühlkörper nach Anspruch 7, wobei das Steigrohr (202) zum Empfangen der ersten Flüssigkeit aus dem Separator (206) ausgelegt ist.

9. Thermosiphon-Kühlkörper nach einem der Ansprüche 1-8, wobei
die erste Finne ferner eine zweite Fallrohrleitung (603) in Fluidverbindung mit Separator (206) und dem ersten Hohlraum (210) umfasst, wobei die zweite Fallrohrleitung (603) zu Folgendem ausgelegt ist: Empfangen von Dampf, der aus dem Separator (206) strömt, Erleichtern der Kondensation des empfangenen Dampfs und Ermöglichen, dass Flüssigkeit, die aus der Kondensation des empfangenen Dampfs resultiert, durch die Schwerkraft nach unten zum ersten Hohlraum (210) strömt.

10. Thermosiphon-Kühlkörper nach Anspruch 9, wobei die zweite Fallrohrleitung (603) ferner zum Empfangen von Dampf der zweiten Flüssigkeit mit einer zweiten Siedetemperatur ausgelegt ist und wobei die erste Fallrohrleitung (308) ferner zum Empfangen von Dampf der ersten Flüssigkeit mit einer ersten Siedetemperatur ausgelegt ist, die höher als die zweite Siedetemperatur ist.

11. Thermosiphon-Kühlkörper nach einem der Ansprüche 1-6, wobei das Flüssigkeitsgemisch aus einer einzigen Flüssigkeit besteht.

12. Kommunikationssystem (100), umfassend:
eine Komponente (192) und
den TSHS (101) nach Anspruch 1, der mit der Komponente (192) verbunden ist.

13. Kommunikationssystem nach Anspruch 12, wobei die Komponente einen Leistungsverstärker umfasst.

## Revendications

1. Dissipateur thermique à thermosiphon (101) à utiliser pour refroidir au moins un premier composant (192) d'un système de communication (100), comprenant :
une base (102) ; et
une première ailette (104) fixée à la base, dans lequel la base comprend :
une première cavité (210) remplie d'un mélange liquide ;
un premier évaporateur (208) au-dessus de la première cavité (210) et comprenant un premier conduit d'évaporation (304) ;
un premier séparateur (206) séparé de la première cavité (210) par le premier évaporateur (208), dans lequel le premier conduit d'évaporation (304) est en communication fluidique avec la première cavité (210) et le premier séparateur (206) et le premier conduit d'évaporation (304) est configuré pour permettre à un liquide et à une vapeur présents dans le premier conduit d'évaporation de circuler vers le haut jusqu'au premier séparateur (206) ;
une première colonne montante (202) comprenant un premier conduit de colonne montante (306) s'étendant vers le haut à partir du premier séparateur (206) pour permettre à une vapeur de circuler vers le haut dans une première région de distribution de vapeur (390), et
la première ailette (104) comprend :
un premier condensateur (204) comprenant un premier conduit de colonne descendante (308) en communication fluidique avec la première région de distribution de vapeur (390) et la première cavité (210), le premier conduit de colonne descendante (308) étant configuré pour : recevoir une vapeur sortant de la première région de distribution de vapeur (390), faciliter une condensation de la vapeur reçue, et permettre à un liquide découlant de la condensation de la vapeur reçue de circuler vers le bas jusqu'à la première cavité (210) sous l'effet de la force de gravité.

2. Dissipateur thermique à thermosiphon selon la revendication 1, dans lequel la base (102) inclut également un premier conduit de retour de liquide (302) en communication fluidique avec le premier séparateur (206) et la première cavité (210), le premier conduit de retour de liquide (302) permettant au liquide présent dans le premier séparateur (206) de circuler vers le bas depuis le premier séparateur (206) jusqu'à la première cavité sous l'effet de la force de gravité.

3. Dissipateur thermique à thermosiphon selon la revendication 1 ou 2, comprenant en outre une deuxième ailette (106) comprenant un deuxième condensateur (504) en communication fluidique avec la région de distribution de vapeur (390) et la première cavité (210) pour recevoir une vapeur sortant de la région de distribution de vapeur (390), faciliter la condensation de la vapeur reçue, et permettre à un liquide découlant de la condensation de la vapeur reçue de circuler vers le bas jusqu'à la première cavité (210) sous l'effet de la force de gravité.

4. Dissipateur thermique à thermosiphon selon l'une quelconque des revendications 1 à 3, dans lequel la première cavité comprend une première chambre (414) au-dessus d'une deuxième chambre (412) et un canal (415) relie la première chambre à la deuxième chambre.

5. Dissipateur thermique à thermosiphon selon l'une quelconque des revendications 1 à 4, dans lequel
le premier condensateur (204) inclut une section de retour (212) reliée à la première cavité (210), et
la section de retour (212) est inclinée vers le haut d'au moins 5 degrés pour faciliter la circulation du liquide dans la première cavité (210) depuis le premier condensateur (204).

6. Dissipateur thermique à thermosiphon selon l'une quelconque des revendications 1 à 5, dans lequel
la première colonne montante comprend N conduits de colonne montante, et
le premier condensateur comprend un conduit de colonne descendante pour chacun des N conduits de colonne montante.

7. Dissipateur thermique à thermosiphon selon l'une quelconque des revendications 1 à 6, dans lequel
le mélange liquide comprend un premier liquide présentant une première température d'ébullition et un deuxième liquide présentant une deuxième température d'ébullition inférieure à la première température d'ébullition du premier liquide.

8. Dissipateur thermique à thermosiphon selon la revendication 7, dans lequel la colonne montante (202) est configurée pour recevoir le premier liquide depuis le séparateur (206).

9. Dissipateur thermique à thermosiphon selon l'une quelconque des revendications 1 à 8, dans lequel
la première ailette comprend en outre un deuxième conduit de colonne descendante (603) en communication fluidique avec le séparateur (206) et la première cavité (210), le deuxième conduit de colonne descendante (603) étant configuré pour : recevoir une vapeur sortant du séparateur (206), faciliter une condensation de la vapeur reçue, et permettre à un liquide découlant de la condensation de la vapeur reçue de circuler vers le bas vers la première cavité (210) sous l'effet de la force de gravité.

10. Dissipateur thermique à thermosiphon selon la revendication 9, dans lequel le deuxième conduit de colonne descendante (603) est en outre configuré pour recevoir une vapeur du deuxième liquide présentant une deuxième température d'ébullition et dans lequel le premier conduit de colonne descendante (308) est en outre configuré pour recevoir une vapeur du premier liquide présentant une première température d'ébullition supérieure à la deuxième température d'ébullition.

11. Dissipateur thermique à thermosiphon selon l'une quelconque des revendications 1 à 6, dans lequel le mélange liquide comprend un seul liquide.

12. Système de communication (100), comprenant :
un composant (192) ; et
le dissipateur thermique à thermosiphon (101) selon la revendication 1 relié au composant (192).

13. Système de communication selon la revendication 12, dans lequel le composant comprend un amplificateur de puissance.
